# DEMANDE DE BREVET EUROPEEN

(11) **EP 2 315 211 A1**
(43) Date de publication de la demande: **27.04.2011**
(21) Numéro de dépôt: 10187015.2
(22) Date de dépôt: 08.10.2010
(51) Int. Cl.: G11C 8/06, G11C 16/08, G06F 12/02, G06F 12/06, G06F 13/16, G11C 8/04

(54) **Dispositif de mémoire à protocole série et procédé d'adressage correspondant**

(30) Priorité: 13.10.2009 FR 0957155
(71) Demandeur: STMicroelectronics (Rousset) SAS, 13790 Rousset (FR)
(72) Inventeur: Tailliet, François, 13710 Fuveau (FR)
(74) Mandataire: Zapalowicz, Francis

(57) **Abrégé**

Le dispositif de mémoire comprend un plan mémoire physique (PMP) comportant m premières rangées physiques (RGPli) s'étendant selon une première direction et n deuxièmes rangées physiques (RGP2j) s'étendant selon une deuxième direction, des moyens de réception pour recevoir une adresse logique (ADR) désignant une première rangée logique (RGli) et une deuxième rangée logique (RG2j) d'un plan mémoire logique matriciel (PML), possédant 2^{p} premières rangées logiques s'étendant selon la première direction et 2^{q} deuxièmes rangées logiques s'étendant selon la deuxième direction, en ce que en ce que m et n sont chacun différents d'une puissance de deux, m étant un multiple de 2^{k}, k étant inférieur ou égal à p, et le produit de m par n étant égal à l'entier le plus proche par excès de 2^{p+q}, et en ce qu'il comprend des moyens d'adressage du plan mémoire physique (PMP) configurés pour adresser une première rangée physique et une partie seulement d'une deuxième rangée physique à partir du contenu de ladite adresse logique reçue et du reste d'une division euclidienne d'une partie du contenu de cette adresse logique reçue par m/2^{k}.

## Description

L'invention concerne les mémoires, en particulier celles fonctionnant avec un protocole série, et plus particulièrement la mise en boîtier de telles mémoires.

L'invention s'applique avantageusement mais non limitativement aux mémoires non volatiles de type électriquement effaçable et programmable (EEPROM).

Actuellement, on vise à offrir la plus grosse densité de mémoire dans le plus petit boîtier possible.

Il existe actuellement des mémoires ayant une capacité de 1 Mégabits logées dans des boîtiers de type SO8N

La prochaine étape est d'offrir un boîtier SOBN contenant une mémoire ayant une capacité de 2 Mégabits.

La contrainte est de faire rentrer le circuit de mémoire dans la place disponible dans le boîtier. Or, pour une mémoire 2 Mégabits, l'essentiel de la surface est occupée par le plan-mémoire dont on ne peut pas adapter facilement le routage comme on le fait pour les circuits périphériques. En effet, les mémoires sont organisées en matrices avec un nombre de rangées et un nombre de colonnes égaux à une puissance de 2.

De ce fait, le plan-mémoire a une forme donnée et on fait éventuellement le routage des circuits périphériques pour adapter la forme du circuit au boîtier voulu.

Il existe différentes versions d'un boîtier donné. Elles sont entre autres caractérisées par la dimension de la plaque métallique au centre du boîtier sur laquelle est collée la puce supportant le circuit de mémoire. Cette plaque métallique détermine la dimension maximale de la puce, laquelle doit être plus petite que celle-ci, avec une marge minimale définie.

Lorsque les dimensions de la puce sont importantes, on choisit la plaque métallique la plus grande possible et on essaie de dessiner la périphérie du circuit de mémoire pour l'adapter à la dimension de cette plaque métallique. Il arrive parfois qu'on doive violer les règles d'assemblage, ou qu'on utilise des plaques non standard, ce qui se traduit souvent par des surcoûts et des problèmes de production et de qualité.

Dans tous les cas, la marge de manoeuvre est faible.

Le pire cas est celui de mémoires de grande capacité dont la surface atteint la surface maximale disponible dans le boîtier, car les dimensions en X et en Y du plan-mémoire sont imposées. La faible proportion de la surface à la périphérie par rapport à la surface du plan-mémoire donne ainsi peu de flexibilité quant à l'adaptation des dimensions du circuit à la forme de la plaque métallique.

Il se peut alors que l'on arrive à une impossibilité.

Ceci est d'autant plus critique pour les mémoires programmables par page, comme par exemple les mémoires EEPROM organisées en pages mémoire. En effet pour ce type de mémoire, une page est la quantité de données (des octets par exemple) que l'on peut programmer simultanément. Et cette contrainte de page impose l'architecture de la mémoire.

Selon un mode de mise en oeuvre, il est proposé de modifier la forme du plan-mémoire d'une mémoire pour pouvoir adapter avec plus de facilité la forme du circuit de mémoire à la dimension de la plaque métallique du boîtier, ce qui est particulièrement difficile dans le cas des mémoires organisées en pages, comme par exemple des mémoires EEPROM, compte tenu de la contrainte importante d'architecture liée à la programmation possible par page.

Il devient alors possible de placer une mémoire dans un boîtier plus petit que celui habituellement utilisé.

Selon un mode de réalisation, adapté en particulier mais non limitativement aux mémoires EEPROM série programmables par page, il est prévu de modifier la forme du plan-mémoire de façon que le nombre de rangées (lignes) et de colonnes ne soit pas une puissance de 2. Par ailleurs, on adresse les colonnes par un décodage d'adresse très simple utilisant une division euclidienne effectuée à la volée, ce qui est permis par le protocole série. Enfin, on utilise un plan-mémoire équipé de plusieurs décodeurs lignes (« Row decoder » selon une dénomination anglosaxonne bien connue de l'homme du métier), chaque décodeur ligne ne pouvant accéder qu'à une partie particulière du plan-mémoire et par ailleurs, ne décodant pas toutes les lignes séquentiellement.

Plus généralement, et selon un aspect, il est proposé un dispositif de mémoire, en particulier à protocole série, comprenant un plan-mémoire physique comportant m rangées physiques s'étendant selon une première direction (par exemple m colonnes) et n deuxièmes rangées physiques s'étendant selon une deuxième direction (par exemple n lignes) ; le dispositif de mémoire comprend par ailleurs des moyens de réception pour recevoir une adresse logique désignant une première rangée logique et une deuxième rangée logique d'un plan-mémoire logique matriciel possédant 2^{P} premières rangées logiques s'étendant selon la première direction, et 2^{q} deuxièmes rangées logiques s'étendant selon la deuxième direction ;

m et n sont chacun différents d'une puissance de 2, m est un multiple de 2^{k}, ou k est un entier inférieur ou égal à p, et le produit de m par n est égal à l'entier le plus proche par excès de 2^{p+q} ;

le dispositif comprend par ailleurs des moyens d'adressage du plan-mémoire physique, configurés pour adresser une première rangée physique (par exemple une colonne) et une partie seulement d'une deuxième rangée physique (par exemple une ligne) à partir du contenu de ladite adresse logique reçue et du reste d'une division euclidienne d'une partie du contenu de cette adresse logique reçue par m/2^{k}.

Ainsi, pour une mémoire possédant 256 colonnes logiques (p=8) et 1024 lignes logiques (q=10) et si l'on choisit k=7 (2^{k}=128), on peut adopter un plan-mémoire physique comportant 384 colonnes (m=384 ; m=3 x 2⁷) et 683 lignes physiques.

L'adressage du plan-mémoire s'effectuera à partir notamment du reste d'une division euclidienne par 3 (384/128) avec par exemple, comme on le verra plus en détail ci-après, deux décodeurs lignes seulement, chacun des décodeurs lignes ne décodant que deux tiers des lignes logiques.

L'adresse logique reçue comporte un premier champ, par exemple un champ de colonne, associé à ladite première rangée logique, et un deuxième champ, par exemple un champ de ligne, associé à la deuxième rangée logique. Selon un mode de réalisation compatible avec une mémoire à protocole série, les moyens d'adressage comportent des premiers moyens de décodage comportant des moyens de calcul configurés pour effectuer à la volée la division euclidienne du contenu dudit deuxième champ par m/2^{k}, et des premiers moyens de sélection, configurés pour sélectionner ladite première rangée physique à partir du contenu dudit premier champ et du reste de la division euclidienne.

Le protocole série permet en effet d'effectuer la division euclidienne à la volée, c'est-à-dire par exemple au rythme de réception des bits d'adresse ; En d'autres termes la division euclidienne est effectuée bit à bit de façon synchrone à l'arrivée des bits.

les moyens d'adressage comportent par ailleurs des deuxièmes moyens de décodage configurés pour adresser ladite partie de ladite deuxième rangée physique à partir du contenu dudit deuxième champ.

Selon un mode de réalisation, les moyens de calcul comportent un registre de reste destiné à recevoir séquentiellement les bits du deuxième champ, bit de poids fort en tête, et un circuit logique rebouclé sur le registre de reste et configuré pour délivrer séquentiellement au registre de reste la valeur binaire du reste de la division euclidienne par m/2^{k} du dividende formé par le contenu du registre de reste concaténé à droite par le bit courant reçu du deuxième champ.

En d'autres termes, le registre de reste sert à la fois de stockage des dividendes successifs et du reste final de la division euclidienne.

Le registre de reste possède ainsi par exemple nb+1 étages, où nb désigne le nombre compatible avec la valeur binaire maximale du reste de ladite division euclidienne (nb=2 pour une division euclidienne par trois dans laquelle la valeur maximale binaire du reste est égale à 1 0), et le circuit logique possède nb+1 entrées couplées aux nb+1 étages du registre et nb sorties couplées à nb premiers étages du registre de reste.

Les moyens de réception comportent avantageusement un premier registre d'adresse, par exemple un registre d'adresse colonne, configuré pour stocker le contenu du premier champ, et un deuxième registre d'adresse, par exemple un registre d'adresse ligne, configuré pour stocker le contenu du deuxième champ. Le premier registre d'adresse possède une sortie de retenue connectée à une entrée d'incrémentation du deuxième registre d'adresse.

Selon un mode de réalisation permettant notamment une lecture séquentielle de la mémoire, communément désignée par l'homme du métier sous la dénomination anglosaxonne de « sequential read », le registre de reste comporte une entrée d'incrémentation, le deuxième registre d'adresse comporte une sortie de retenue, et les premiers moyens de décodage comprennent des moyens de commande possédant
une entrée de commande destinée à recevoir un signal de commande de lecture séquentielle,
une première entrée connectée à la sortie de retenue du premier registre d'adresse,
une deuxième entrée connectée à la sortie de retenue du deuxième registre d'adresse, et
une sortie de commande connectée à l'entrée d'incrémentation du registre de reste, et destinée à délivrer un signal de commande d'incrémentation dont la valeur logique est conditionnée à la valeur du signal de commande de lecture séquentielle et à celles des signaux présents à la première entrée et à la deuxième entrée.

Le registre de reste comporte par ailleurs avantageusement des moyens de contrôle configurés pour autoriser une incrémentation séquentielle et cyclique de la valeur du contenu du registre de reste entre la valeur binaire nulle et la valeur binaire correspondant à m/2^{k}-l. Ainsi, la valeur m/2^{k}, qui est une valeur interdite, n'est jamais atteinte par le registre de reste.

Bien qu'il soit possible, dans certaines applications, d'utiliser le quotient de la division euclidienne pour décoder les deuxièmes rangées logiques, par exemple les lignes, il est particulièrement simple que les deuxièmes moyens de décodage comportent plusieurs deuxièmes décodeurs capables de décoder l'ensemble des deuxièmes rangées logiques, chaque deuxième décodeur étant configuré pour décoder certaines seulement des deuxièmes rangées logiques, et le décodeur ou chaque décodeur affecté à la deuxième rangée logique désignée par le contenu du deuxième champ de ladite adresse logique reçue est configuré pour accéder à une partie seulement d'une deuxième rangée physique.

Un tel mode de réalisation est d'ailleurs compatible avec une lecture séquentielle de la mémoire et avec une programmation de la mémoire en mode page.

Bien qu'il soit possible d'utiliser par exemple des moyens de programmation électroniques capables de n'autoriser qu'un accès à une partie seulement d'une deuxième rangée physique pour un deuxième décodeur, il est plus simple de prévoir un câblage physique limitant l'accès des deuxièmes décodeurs aux parties de deuxièmes rangées physiques.

Bien qu'il soit possible d'utiliser plus que deux deuxièmes décodeurs, il est particulièrement simple d'utiliser uniquement deux deuxièmes décodeurs.

Ainsi, dans un tel cas, l'un des deuxièmes décodeurs peut être configuré pour pouvoir décoder séquentiellement les deuxièmes rangées logiques à partir de la première en omettant de décoder une rangée logique sur m/2^{k} et l'autre deuxième décodeur peut être configuré pour pouvoir décoder séquentiellement les rangées logiques à partir de la deuxième, en omettant de décoder une rangée logique sur m/2^{k}_{.}

Selon un mode de réalisation, m est égal à 2^{P} + 2^{k}, k étant un entier positif ou nul et inférieur ou égal à p-1.

Selon un mode de réalisation, correspondant par exemple à une organisation de la mémoire en pages-mémoire, les 2^{q} deuxièmes rangées logiques du plan mémoire logique correspondent à 2^{q} pages logiques comportant chacune 2^{p} emplacements-mémoire logiques configurés pour stocker respectivement 2^{p} données, et le plan mémoire physique comporte n pages physiques dont n-1 sur les n comportent chacune 2^{p} + 2^{k} emplacements-mémoire physiques et correspondent chacune à une page logique et à une partie d'une page logique de rang voisin, et dont l'une comporte 2^{p} emplacements-mémoire physiques et correspond à une partie au moins d'une page logique.

Selon un mode de réalisation, les premiers moyens de sélection comportent
1+2^{p-k} blocs de décodage, chaque bloc de décodage étant configuré pour adresser le plan mémoire physique par blocs de 2^{k} données à partir des k bits de poids faibles du premier champ et connecté à un bloc de 2^{k} premières rangées physiques,
un module de sélection configuré pour sélectionner un bloc de décodage parmi les 1+2^{p-k} blocs de décodage à partir du reste de ladite division euclidienne et des p-k bits de poids forts dudit premier champ.

Les deuxièmes décodeurs, par exemple les décodeurs lignes, peuvent être disposés entre certains au moins des blocs de 2^{k} premières rangées physiques.

En variante, lorsqu'il est prévu d'utiliser uniquement deux deuxièmes décodeurs, ceux-ci peuvent être respectivement disposés à deux extrémités du plan-mémoire physique.

Le plan-mémoire peut être du type non volatil et électriquement effaçable et programmable.

Selon un autre aspect, il est proposé un boîtier contenant un dispositif de mémoire tel que défini ci-avant, ce boîtier pouvant être du type SO8N tel que défini par la norme JEDEC, ou bien un boîtier du type TSSOP8, et contenir un dispositif de mémoire de capacité supérieure à 1 Mégabits, par exemple 2 Mégabits.

Selon un autre aspect, il est proposé un procédé d'adressage d'un dispositif de mémoire, en particulier à protocole série, comprenant un plan mémoire physique correspondant à un plan-mémoire logique matriciel, possédant 2^{p} premières rangées logiques s'étendant selon une première direction et 2^{q} deuxièmes rangées logiques s'étendant selon une première direction, le plan mémoire physique comportant m premières rangées physiques s'étendant selon la première direction et n deuxièmes rangées physiques s'étendant selon la deuxième direction, m et n étant chacun différent d'une puissance de deux, m étant un multiple de 2^{k}, k étant inférieur ou égal à p, et le produit de m par n étant égal à l'entier le plus proche par excès de 2^{p+q}, procédé comprenant un premier mode d'adressage comportant une réception d'une adresse logique désignant une première rangée logique et une deuxième rangée logique et un adressage d'une première rangée physique et d'une partie seulement d'une deuxième rangée physique à partir du contenu de ladite adresse logique et du reste d'une division euclidienne d'une partie du contenu de cette adresse logique par m/2^{k}.

Selon un mode de mise en oeuvre, ladite adresse logique comporte un premier champ associé à ladite première rangée logique et un deuxième champ associé à ladite deuxième rangée logique, et ledit adressage comporte un calcul du reste d'une division euclidienne, avantageusement effectuée à la volée, du contenu dudit deuxième champ par m/2^{k} et une sélection de ladite première rangée physique à partir du contenu dudit premier champ et dudit reste de la division euclidienne, et un adressage de ladite partie de ladite deuxième rangée physique à partir du contenu dudit deuxième champ.

Selon un mode de mise en oeuvre, le calcul dudit reste comporte un stockage séquentiel des bits du deuxième champ, bit de poids fort en tête, dans un registre de reste et un calcul et une délivrance séquentielle au registre de reste de la valeur binaire du reste de la division euclidienne par m/2^{k} du dividende formé par le contenu courant du registre de reste concaténé à droite par le bit courant reçu du deuxième champ.

Selon un mode de mise en oeuvre, le procédé comprend en outre un mode de lecture séquentielle comportant après réception d'une adresse logique et calcul d'une première valeur du reste de la division euclidienne une incrémentation séquentielle et cyclique de la valeur du contenu du registre de reste à partir de ladite première valeur et entre la valeur binaire nulle et la valeur binaire correspondant à m/2^{k} ― 1.

Selon un mode de mise en oeuvre, l'adressage des parties de deuxièmes rangées physiques s'effectue avec plusieurs deuxièmes décodeurs capables de décoder l'ensemble des deuxièmes rangées logiques, on configure chaque deuxième décodeur pour décoder certaines seulement des deuxièmes rangées logiques, et on accède à une partie seulement d'une deuxième rangée physique avec le décodeur ou chaque décodeur affecté à la deuxième rangée logique désignée par le contenu du deuxième champ de ladite adresse logique reçue.

Selon un mode de mise en oeuvre, on utilise seulement deux deuxièmes décodeurs.

Selon un mode de mise en oeuvre, on configure l'un des deuxièmes décodeurs pour pouvoir décoder séquentiellement lesdites rangées logiques à partir de la première en omettant de décoder une rangée logique sur m/2^{k}, et on configure l'autre deuxième décodeur pour pouvoir décoder séquentiellement lesdites rangées logiques à partir de la deuxième en omettant de décoder une rangée logique sur m/2^{k}_{.}

Selon un mode de mise en oeuvre, le procédé s'applique à l'adressage d'un plan-mémoire dans lequel m est égal à 2^{p} + 2^{k}, k étant un entier positif ou nul et inférieur ou égal à p-1.

Le procédé trouve également une application très avantageuse aux mémoires programmables par page et s'applique également en particulier à l'adressage d'un plan-mémoire dans lequel les 2^{q} deuxièmes rangées logiques du plan mémoire logique correspondent à 2^{q} pages logiques comportant chacune 2^{p} emplacements-mémoire logiques configurés pour stocker respectivement 2^{p} données, et le plan-mémoire physique comporte n pages physiques dont n-1 sur les n comportent chacune 2^{p} + 2^{k} emplacements-mémoire physiques et correspondent chacune à une page logique et à une partie d'une page logique de rang voisin, et dont l'une comporte 2^{p} emplacements-mémoire physiques et correspond à une partie au moins d'une page logique.

Dans ce cas, et selon un mode de mise en oeuvre, la sélection de ladite première rangée physique à partir du contenu dudit premier champ et dudit reste de la division euclidienne comprend une sélection d'un bloc de 2^{k} premières rangées physiques à partir du reste de ladite division euclidienne et des p-k bits de poids forts dudit premier champ, et une sélection de ladite première rangée physique à partir des k bits de poids faibles du premier champ.

D'autres avantages et caractéristiques de l'invention apparaîtront à l'examen de la description détaillée de modes de réalisation et de mise en oeuvre, nullement limitatifs, et des dessins annexés sur lesquels :
- la figure 1 illustre schématiquement un exemple de plan-mémoire logique et de plan-mémoire physique selon l'invention ;
- les figures 2 à 4 illustrent schématiquement un exemple de calcul du reste d'une division euclidienne selon l'invention ;
- les figures 5a à 5d, 6 et 7 illustrent schématiquement un exemple d'adressage d'un plan-mémoire physique selon l'invention ;
- la figure 8 illustre un schéma bloc d'un exemple de réalisation d'un dispositif de mémoire selon l'invention ;
- les figures 9 à 16 illustrent plus en détail mais toujours schématiquement certaines parties du dispositif illustré sur la figure 8 ;
- les figures 17 à 19 illustrent trois chronogrammes relatifs à trois exemples de fonctionnement d'un dispositif selon l'invention;
- les figures 20 et 21 illustrent schématiquement un exemple de placement d'un dispositif de mémoire selon l'invention dans un boîtier ; et
- les figures 22a à 22e et 23 illustrent schématiquement un autre exemple de dispositif de mémoire selon l'invention.

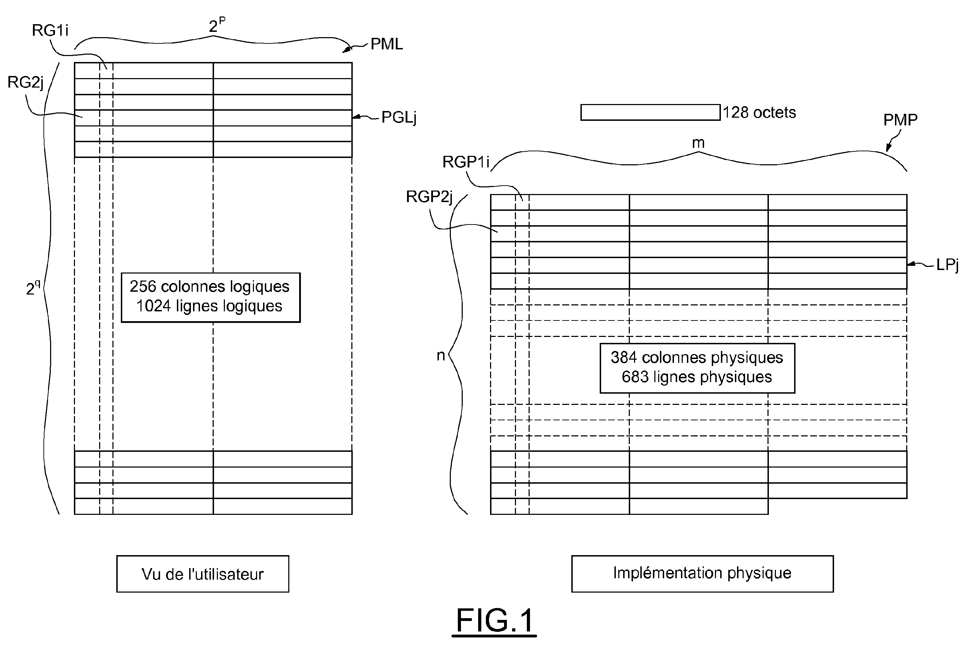

Sur la figure 1, la référence PML désigne un plan-mémoire logique, c'est-à-dire un plan-mémoire vu de l'utilisateur, comportant 2^{p} premières rangées logiques RGli (des colonnes dans cet exemple) et 2^{q} deuxièmes rangées logiques RG2j (des lignes dans cet exemple).

Dans cet exemple, le plan-mémoire logique comporte 256 colonnes logiques (p=8) et 1024 (q=10) lignes logiques. La mémoire est par ailleurs, vue de l'utilisateur, organisée en pages, c'est-à-dire que chacune des lignes logiques correspond à une page logique PGLj de la mémoire. Et chaque page comporte ici deux groupes de 128 emplacements-mémoire ou « colonnes » correspondant à deux groupes de 128 octets. En effet, chaque emplacement-mémoire de la mémoire est susceptible de stocker une donnée sur huit bits. La page représente ainsi la quantité (ici 256) d'octets que l'on peut programmer simultanément.

En conséquence, la mémoire est ici une mémoire d'une capacité de 2 Mégabits. Cette mémoire est dans cet exemple une mémoire EEPROM à protocole série compatible avec les bus série I²C ou SPI.

De façon à pouvoir placer une telle mémoire dans un boîtier de type SO8N on implémente physiquement le plan-mémoire comme illustré par exemple sur la partie droite de la figure 1.

Plus précisément, le plan-mémoire physique PMP comporte m premières rangées physiques ou colonnes RGPli et n deuxièmes rangées physiques ou lignes RGP2j. Dans cet exemple, m est égal à 384 et n est égal à 683.

On remarque donc que m et n sont tous les deux différents d'une puissance de 2. Par ailleurs, m est un multiple de 128 (2^{k} avec k=7).

Enfin, le produit m par n est ici égal à l'entier le plus proche par excès de 256 x 1024.

Le plan-mémoire physique PMP est ici également organisé en pages LPj. Les pages physiques comportent 384 octets et chaque page physique LPj correspond à 1,5 page logique PGLj, PGLj+1.

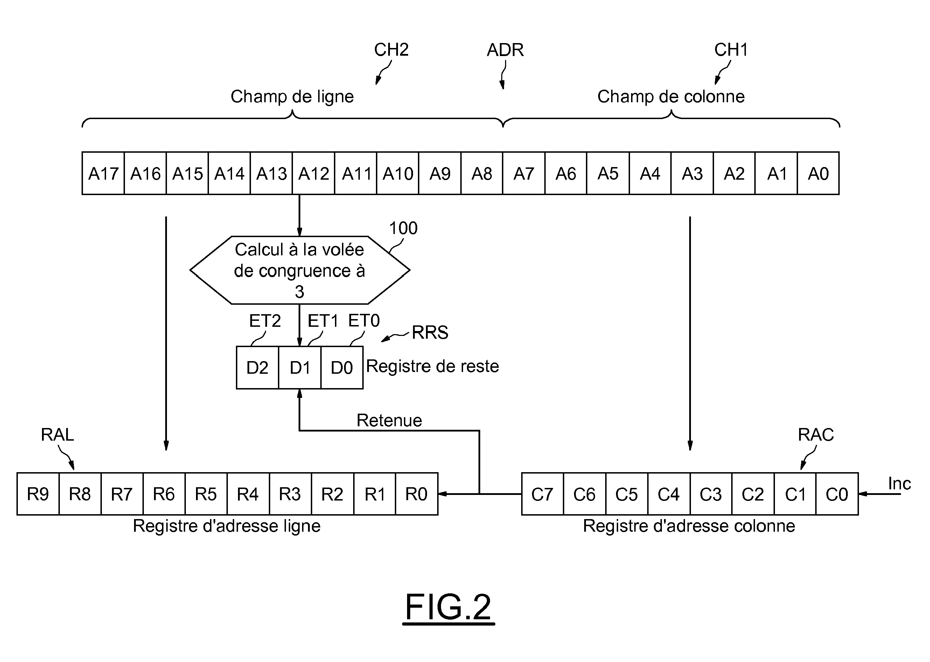

Vu de l'utilisateur, le plan-mémoire logique PML est adressable avec des adresses logiques ADR (figure 2) comportant un premier champ d'adresse CH1 (champ de colonne) et un deuxième champ d'adresse CH2 (champ de ligne). Une adresse logique ADR désigne donc une ligne logique et une colonne logique du plan-mémoire logique PML.

Dans l'exemple décrit ici, le champ de colonne comporte huit bits A0-A7, tandis que le champ de ligne comporte 10 bits A8-A17.

Le dispositif de mémoire est ici à protocole série, c'est-à-dire qu'il reçoit en série, au rythme d'un signal d'horloge, les données (que ces données soient des bits de données ou bien des bits d'adresse).

Les différents bits de l'adresse ADR sont ainsi stockés séquentiellement au rythme du signal d'horloge dans un registre de colonne RAC et dans un registre de ligne RAL qui fonctionnent à cet égard comme des registres à décalage. Le dernier étage C7 du registre colonne RAC est relié au premier étage R0 du registre de ligne RAL.

Par ailleurs, une division euclidienne du contenu du champ de ligne CH2 par m/2^{k}, c'est-à-dire dans cet exemple par trois, est effectuée à la volée (étape 100 figure 2).

Le reste de cette division euclidienne est stockée dans les étages ET1 et ET2 d'un registre de reste RRS.

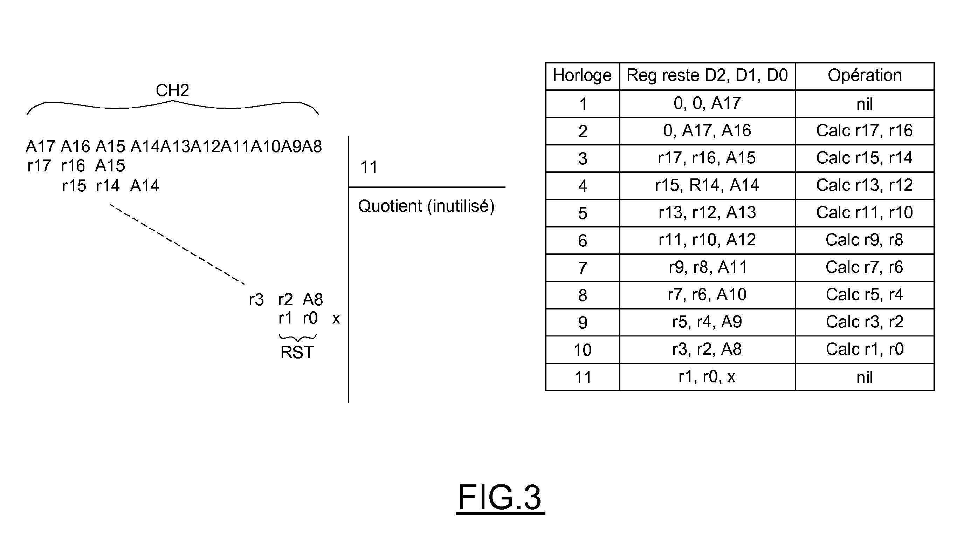

La division euclidienne est effectuée à la volée, c'est-à-dire qu'elle est synchronisée avec la réception des bits d'adresse, réception qui se fait bit de poids fort en tête. Le calcul de la division euclidienne est illustré plus en détail sur la figure 3.

Ainsi, au premier coup d'horloge, le bit A17 du deuxième champ CH2 est stocké dans l'étage ET0 du registre RRS et aucune opération (nil) n'est effectuée.

Au coup d'horloge suivant, le bit A17 est transféré dans l'étage ET1 et l'étage ET0 reçoit le bit A16. Le reste R17, R16 de la division euclidienne par 3 (11 en binaire) est calculé et au coup d'horloge suivant, le registre RRS contient dans ses étages ET2, ET1 et ET0 les valeurs r17, r16 et A15 qui vont constituer le dividende pour la prochaine division par 11 de façon à obtenir le reste intermédiaire r15 et r14.

Ainsi, lors de la division, le registre de reste RRS permet également de stocker les dividendes intermédiaires. A chaque coup d'horloge, un nouveau reste de la division par 3 est calculé selon la table illustrée sur la partie droite de la figure 3.

Le nouveau reste de la division est stocké avec le bit d'adresse suivant reçu. A la fin de la réception des bits du deuxième champ CH2, les étages ET2 et ET1 du registre de reste RRS comportent les bits r1 et r0, c'est-à-dire la valeur du reste de la division euclidienne et fournissent par conséquent la congruence modulo 3.

Les moyens de calcul du reste comportent, outre le registre de reste RRS, un circuit logique MCLR rebouclé sur le registre de reste RRS.

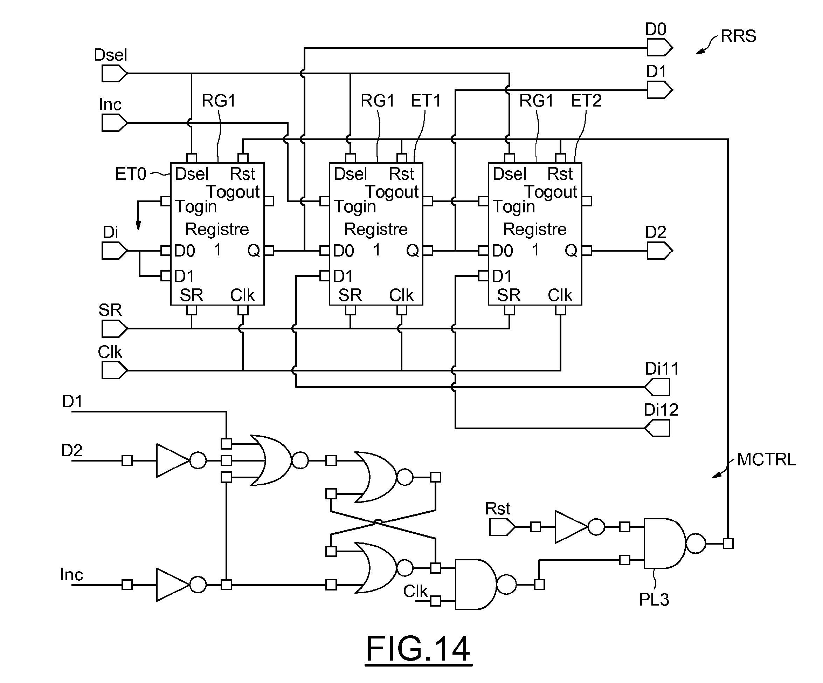

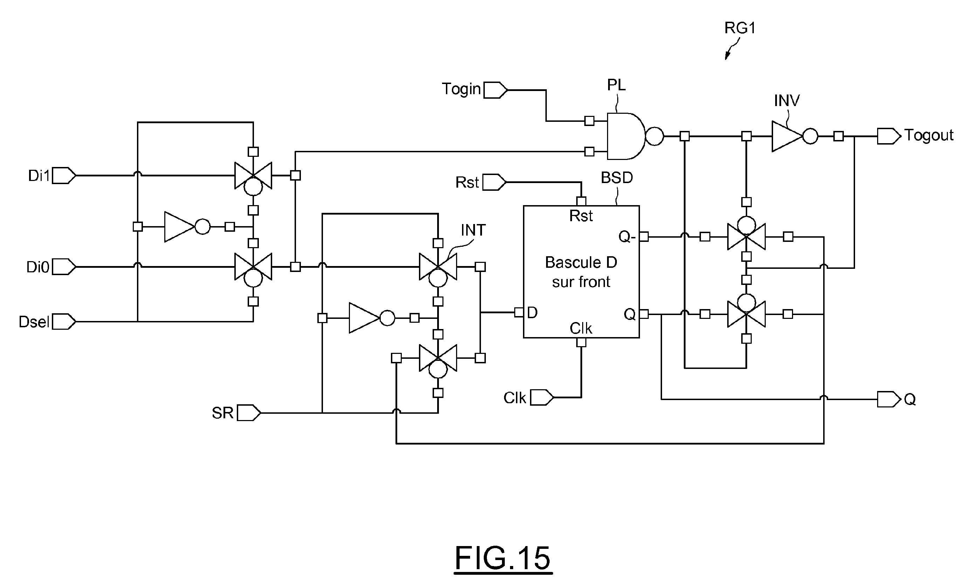

Plus précisément, et comme illustré sur la figure 14 sur laquelle on reviendra plus en détail ci après, le registre de reste RRS comporte ici les trois étages ET0, ET1 et ET2 chacun formés d'un registre RG1 tel que celui illustré schématiquement sur la figure 15. Ce registre RG1 comporte essentiellement une bascule D référencée BSD entourée par des composants logiques comportant ici une porte logique PL, un inverseur INV et des interrupteurs INT formés d'un transistor MOS de type N et d'un transistor MOS de type P montés en parallèle.

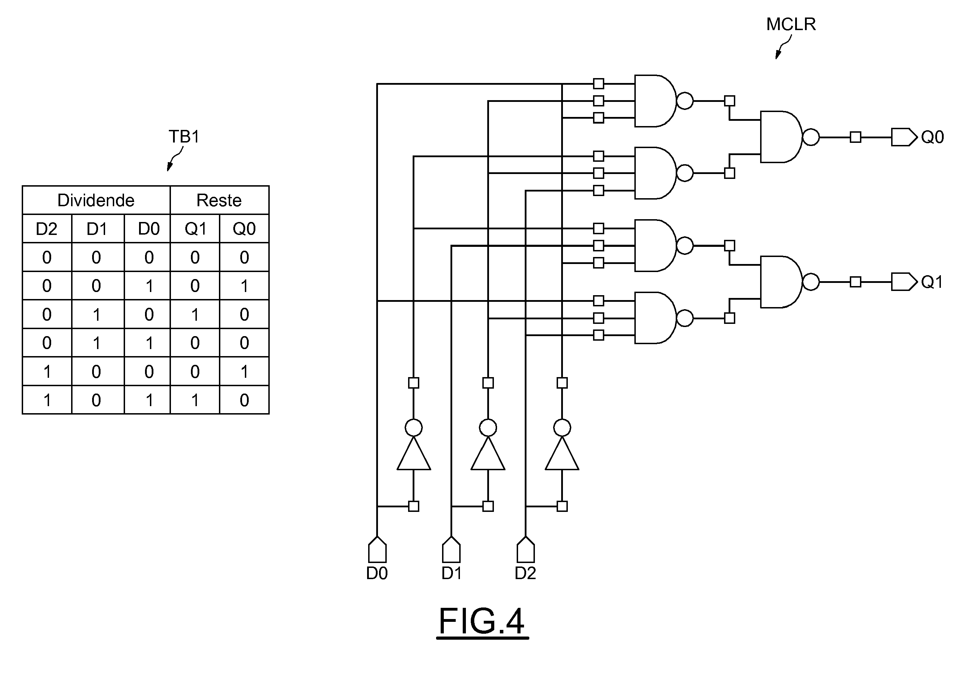

Le circuit logique MCLR (figure 4) comporte trois entrées D0, D1, D2 connectées respectivement aux sorties des étages ET0, ET1 et ET2 du registre de reste RRS et deux sorties Q0 et Q1 rebouclées sur respectivement deux entrées Di11 et Di12 des étages ET1 et ET2.

Dans l'exemple illustré ici d'une division par trois, le circuit logique MCLR est composé de portes logiques et d'inverseurs permettant de calculer les restes successifs de la division euclidienne conformément à la table de vérité TB1 illustrée sur la partie gauche de la figure 4.

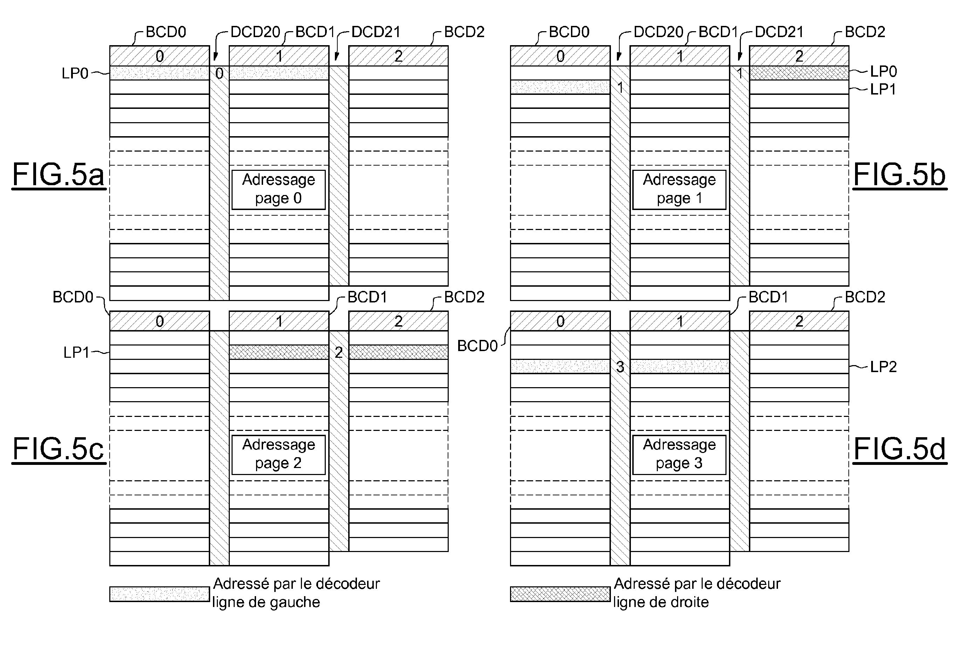

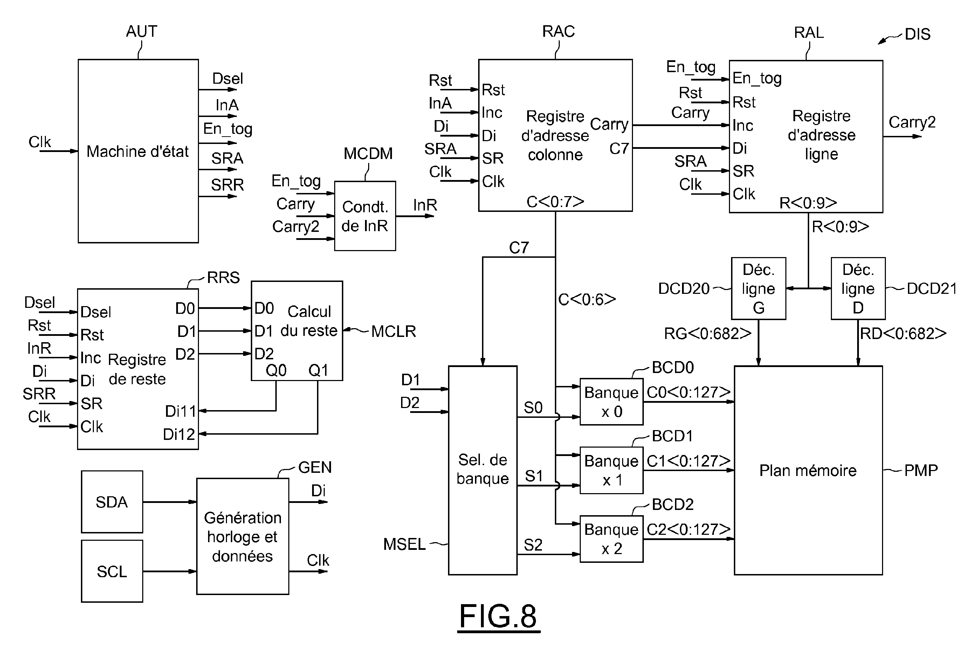

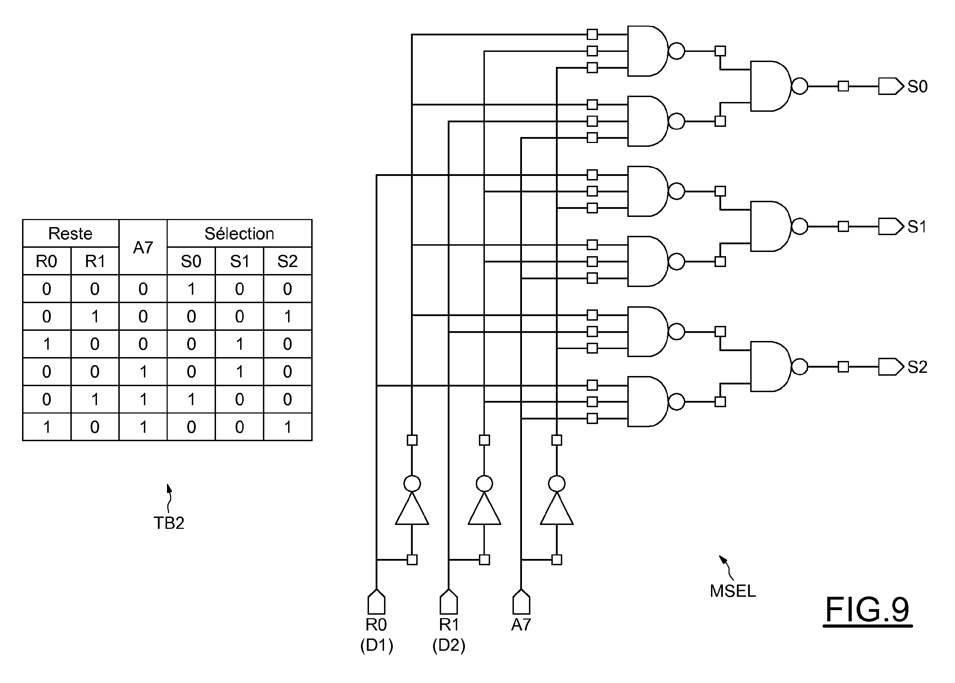

L'architecture du plan-mémoire physique, telle qu'illustrée sur les figures 5a à 5c, comporte, outre les trois blocs de 128 colonnes (128 octets ici), trois blocs de décodage (ou banques) BCD0, BCD1 et BCD2 respectivement affectés aux décodage des 128 colonnes de chaque bloc. L'adressage du plan-mémoire physique se fait donc par blocs de 2^{k} (ici 128) octets. Ces blocs de décodage font partie de premiers moyens de décodage qui vont permettre de décoder les colonnes du plan-mémoire. On verra ci après que ces premiers moyens de décodage comportent également un module de sélection MSEL (figures 8 et 9) permettant de sélectionner un bloc de décodage BCDi parmi les trois blocs de décodage BCDO-BCD2.

Outre les premiers moyens de décodage, le dispositif de mémoire comporte également des deuxièmes moyens de décodage composés ici de deux décodeurs ligne, également appelés deuxièmes décodeurs et référencés DCD20 et DCD21.

Dans l'exemple illustré sur les figures 5, ces deux deuxièmes décodeurs sont placés entre les blocs de 128 colonnes physiques du plan-mémoire physique.

Etant donné qu'une page physique du plan-mémoire physique permet de stocker 1,5 page logique du plan-mémoire logique, il y a trois types d'adressage page différents.

Ces différents types d'adressage sont illustrés sur les figures 5a, 5b et 5c. Plus précisément, la page logique 0 (première page logique) est stockée sur les 256 premiers octets de la ligne physique ou page physique LP0 (figure 5a).

La page logique 1 (figure 5b) est stockée en partie sur la page physique LP0 et en partie sur la page physique LP1. Plus précisément, les 128 premiers octets de la page logique 1 sont stockés sur les 128 derniers octets de la page physique LP0 tandis que les 128 derniers octets de la page logique 1 sont stockés sur les 128 premiers octets de la page physique LP1.

Enfin, comme illustré sur la figure 5c, les deux fois 128 octets de la page logique 2 sont stockés sur les deux derniers groupes de 128 octets de la page physique LP1.

Par contre, comme illustré sur la figure 5d, l'adressage de la page logique 3 s'effectue d'une façon analogue à celui de la page logique 0 mais, cette fois-ci, sur la troisième page physique P2.

Ainsi, dans cet exemple, on a trois types différents d'adressage page, à savoir un type d'adressage page 0 illustré sur la figure 5a, un type d'adressage page 1 illustré sur la figure 5b et un type d'adressage page 2 illustré sur la figure 5c.

Dans le type d'adressage page 0, la page logique est décodée par le deuxième décodeur de gauche DCD20 qui est configuré pour accéder à une partie seulement de la page ou ligne physique correspondante, à savoir dans le cas présent au premier bloc de 128 octets et au deuxième bloc de 128 octets de cette page physique.

Dans un adressage de type page 1, la page logique est décodée par le deuxième décodeur de gauche DCD20 et par le deuxième décodeur de droite DCD21.

Plus précisément, le décodeur de droite DCD21 va décoder les 128 premiers octets de la page logique et est câblé pour n'accéder qu'aux 128 octets de droite de la page physique correspondante.

Le décodeur de gauche DCD20 va décoder les 128 autres octets de la page logique et est câblé pour n'accéder qu'aux 128 premiers octets de la page physique LP1 correspondante.

Enfin, dans un adressage de type page 2, les deux blocs de 128 octets de la page logique sont décodés par le deuxième décodeur de droite DCD21 qui est câblé pour accéder uniquement aux deux blocs de droite de la page physique LP1 correspondante.

Bien entendu, dans chacun de ces types d'adressage, l'un des blocs de décodage BCDi permet, en combinaison avec le deuxième décodeur correspondant, de sélectionner une colonne particulière dans la page physique considérée.

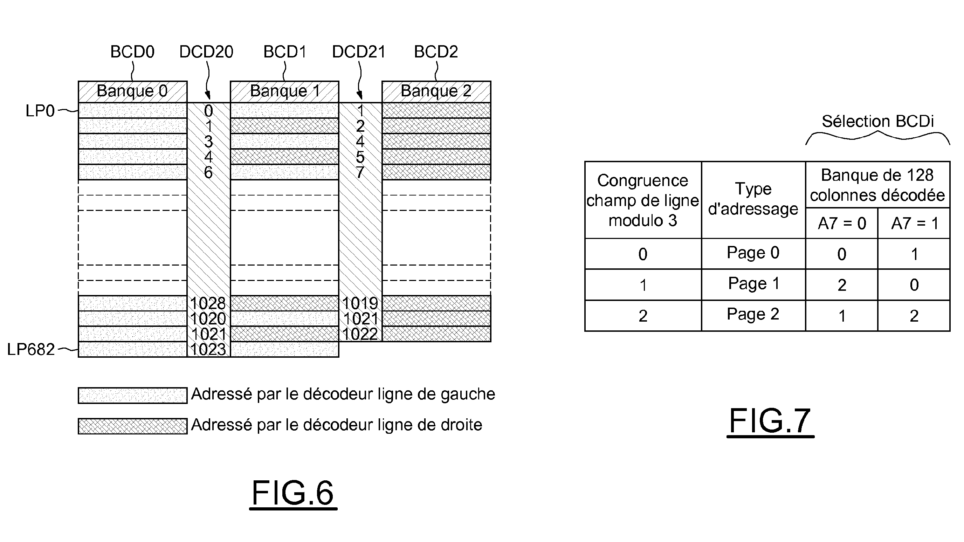

Si l'on se réfère maintenant à la figure 6, on voit que chacun des deuxièmes décodeurs DCD20 et DCD21 ne décodent pas toutes les pages ou lignes logiques du plan-mémoire logique.

Plus précisément, chacun des deuxièmes décodeurs omet de décoder une page logique sur trois. Le deuxième décodeur de gauche DCD20 est configuré pour décoder les pages logiques à partir de la première (numérotée 0) jusqu'à la dernière (numérotée 1023) en omettant de décoder une page logique sur trois, c'est-à-dire les pages logiques numérotées 2, 5, 8, 11, ....., 1022.

Par contre, le deuxième décodeur de droite DCD21 est configuré pour commencer à décoder la deuxième page logique (numérotée 1) jusqu'à l'avant-dernière (numérotée 1022) en omettant également de décoder une page logique sur trois, c'est-à-dire les pages logiques numérotées 0, 3, 6, 9, 12, ....., 1020.

Par ailleurs, comme illustré sur la figure 6, chaque deuxième décodeur est câblé pour n'accéder qu'à une partie seulement d'une page physique.

Comme illustré sur la figure 7, la sélection des blocs de décodage ou banques BCDi s'effectue à partir de la congruence du champ de lignes modulo 3, c'est-à-dire de la valeur du reste de la division euclidienne, et de la valeur du bit de poids fort A7 du champ de colonne CH1.

Ainsi, lorsque le reste vaut zéro, on est alors dans un adressage de type page 0, et si le bit A7 vaut 0, c'est alors le bloc décodage BCD0 qui est sélectionné, tandis que c'est le bloc décodage BCD1 qui est sélectionné si le bit A7 vaut 1.

Si le reste vaut 1, on est alors dans le type d'adressage page 1 et c'est le bloc de décodage BDC2 qui est sélectionné si le bit A7 vaut 0, tandis que c'est le bloc BCD0 qui est sélectionné si le bit A7 vaut 1.

Enfin, si la valeur du reste vaut 2, on est alors dans un adressage de page de type 2 et c'est le bloc BCD1 qui est sélectionné si le bit A7 vaut 0, tandis que c'est le bloc BCD2 qui est sélectionné si le bit A7 vaut 1.

Si l'on se réfère maintenant plus particulièrement à la figure 8 et à la figure 9, on voit que le module de sélection MSEL est effectivement connecté aux deux étages D1 et D2 du registre de reste qui contiennent les bits R0 et R1 du reste ainsi qu'à l'étage C7 du registre de colonne RAC qui contient le bit de poids fort A7. En conséquence, le module de sélection MSEL délivre en sortie les trois bits S0, S1 et S2 conformément à la table de vérité TB2 illustrée sur la partie gauche de la figure 9. Ces trois bits sont respectivement délivrés aux blocs de décodage BCD0, BCD1 et BCD2 aux fins de leur sélection en fonction de la valeur logique de ces bits S0-S2.

Par ailleurs, les sept bits de poids faible A0-A6 du champ de colonne CH1 stockés dans les étages C0 à C6 du registre de colonnes RAC sont délivrés aux blocs de décodage BCD0, BCD1 et BCD2. Ceux-ci délivrent alors un mot de 128 bits permettant de sélectionner la colonne correspondante dans le groupe de colonnes sélectionné.

Par ailleurs, les dix bits A8-A17 du champ de ligne CH2, respectivement stockés dans les étages R0 à R9 du registre d'adresse ligne RAL sont fournis aux deux deuxièmes décodeurs DCD20 et DCD21 qui permettent de décoder la page logique correspondante et d'adresser la portion de page physique correspondante en fonction de leur câblage conformément à ce qui est illustré sur la figure 6.

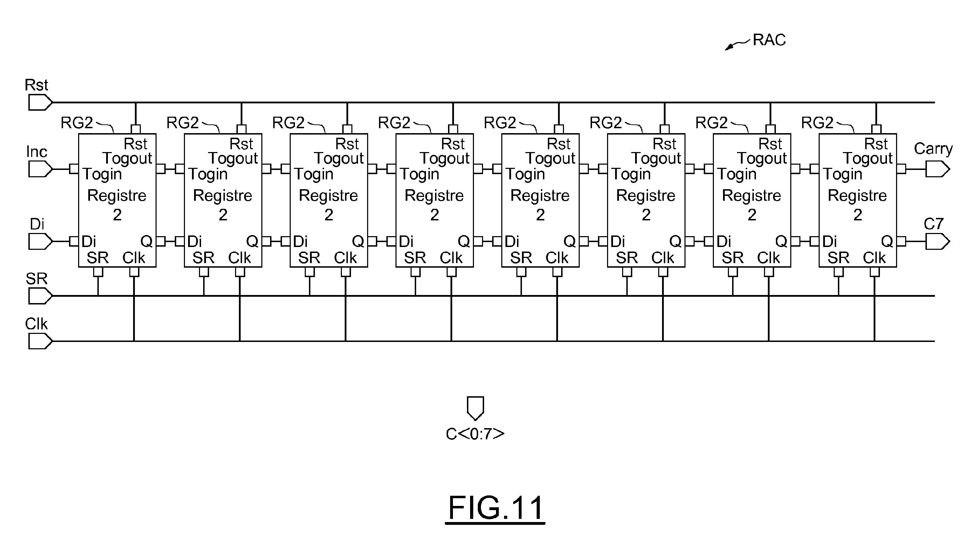

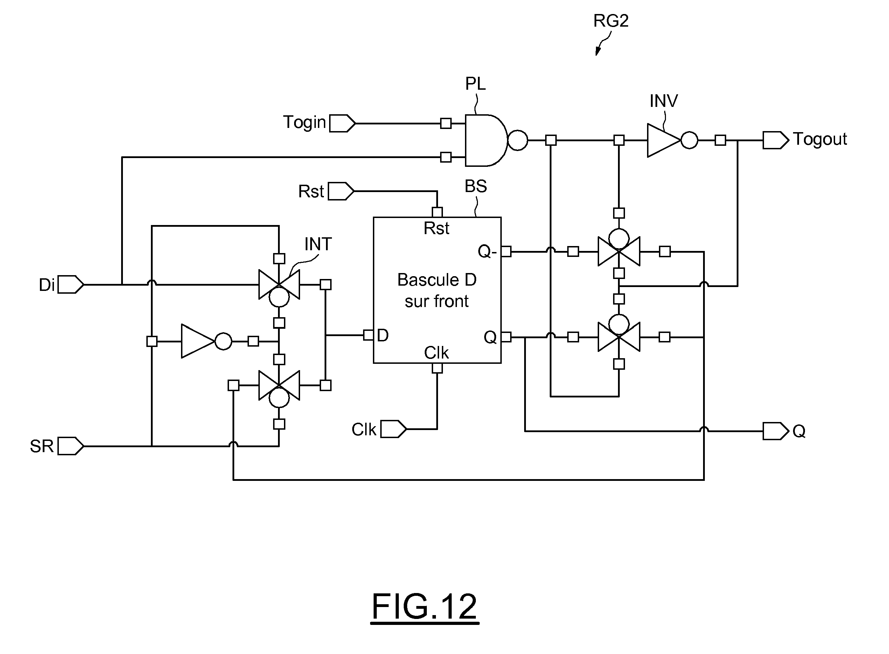

Le registre d'adresse colonne RAC comporte ici, comme illustré sur la figure 11, huit registres RG2 formant les huit étages du registre d'adresse colonne RAC. Un exemple de registre RG2 est illustré sur la figure 12. Tout comme le registre RG1, le registre RG2 est architecturé autour d'une bascule D référencée BS et comporte de la circuiterie logique incluant notamment une porte logique PL, un inverseur INV et des interrupteurs INT.

Le registre d'adresse colonne RAC est cadencé par le signal d'horloge Clk et peut fonctionner en registre à décalage lorsque le signal SRA prend par exemple la valeur logique 1. Ce mode de fonctionnement est notamment utilisé lors du remplissage des bits de l'adresse logique. Le registre RAC peut également ne pas fonctionner en registre à décalage et servir alors simplement de registre de stockage de façon à pouvoir délivrer les huit bits qu'il contient au module de sélection MSEL ainsi qu'aux blocs de décodage BCDi.

Le registre d'adresse colonne comporte également une entrée d'incrémentation Inc, une entrée de données Di et une entrée de réinitialisation Rst. Il possède une sortie de retenue Carry.

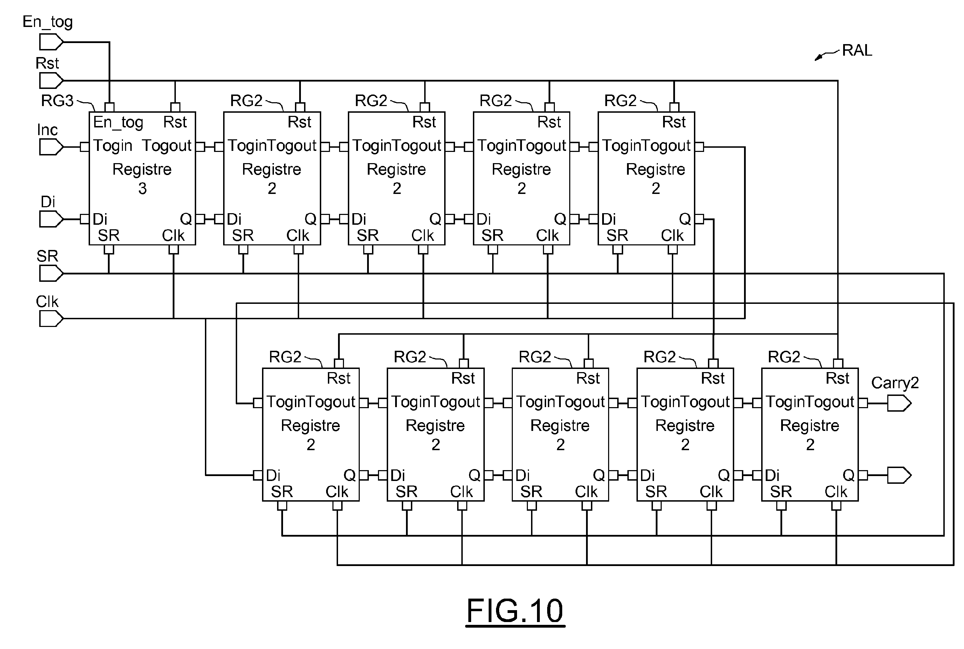

Le registre d'adresse ligne RAL ou deuxième registre d'adresse, comporte dans cet exemple, comme illustré sur la figure 10, dix registres formant les dix étages du registre RAL. Neuf de ces registres sont des registres de type RG2 et le dixième, qui est le registre d'entrée, est un registre du type RG3.

Là encore, ce registre est cadencé par le signal d'horloge Clk et peut fonctionner en registre à décalage en fonction de la valeur logique du signal SRA. Ce fonctionnement en registre à décalage est notamment utilisé lors du stockage d'une adresse logique.

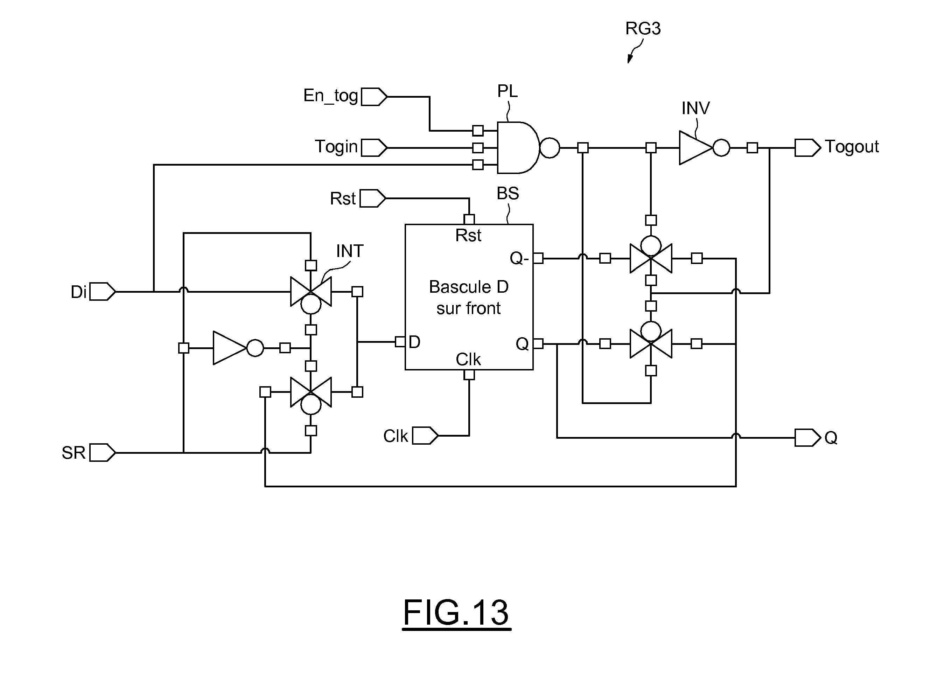

Un exemple de réalisation du registre RG3 est illustré sur la figure 13. Là encore, on retrouve une bascule D référencée BS avec une circuiterie logique comportant une porte logique PL, un inverseur INV et des interrupteurs INT.

Le registre d'adresse ligne RAL peut également être utilisé non pas en registre à décalage mais en simple registre de stockage de façon à pouvoir délivrer les dix bits R du champ d'adresse ligne aux deux décodeurs lignes DCD20 et DCD21.

Le registre d'adresse ligne RAL comporte également une entrée d'incrémentation Inc connectée à la sortie de retenue du registre d'adresse colonne RAC ainsi qu'une entrée de données Di connectée au dernier étage C7 du registre d'adresse colonne RAC.

Le registre d'adresse ligne possède également une entrée de réinitialisation Rst ainsi qu'une entrée de commande En_tog destinée à recevoir un signal de commande de lecture séquentielle En_tog.

On reviendra plus en détail ci après sur ce mode de fonctionnement.

Le registre d'adresse ligne RAL possède également une sortie de retenue Carry2.

Outre les moyens qui viennent d'être décrits, le schéma bloc du dispositif DIS de la figure 8 comportent également le registre de reste RRS avec les moyens de calcul MCLR rebouclés sur le registre de reste RRS. Ce registre de reste comporte également une entrée de remise à zéro Rst, une entrée d'incrémentation Inc, une entrée de données Di, une entrée SR destinée à recevoir un signal logique SRR pour un fonctionnement éventuel du registre de reste en registre à décalage.

Bien entendu, le registre de reste RRS est également cadencé par le signal d'horloge CLK et comporte une entrée Dsel pour recevoir un signal de désélection.

Le signal logique InR est délivré à l'entrée d'incrémentation du registre de reste par des moyens de commande MCDM dont on reviendra plus en détail ci après sur la fonction.

Ces moyens de commande reçoivent en entrée le signal de commande de lecture séquentielle En_tog, le signal de retenue Carry et le signal de retenue Carry2.

Par ailleurs, une machine d'état AUT reçoit le signal d'horloge Clk et délivre les signaux logiques Dsel, le signal logique InA d'incrémentation du registre d'adresse colonne, le signal En_tog ainsi que les signaux de commande pour le fonctionnement en registre à décalage SRA et SRR.

Enfin, des moyens classiques et connus en soi GEN génèrent les signaux de données Di (qui peuvent être des données proprement dites ou bien des données d'adresses) ainsi que le signal d'horloge CLK de façon à satisfaire aux exigences du protocole série.

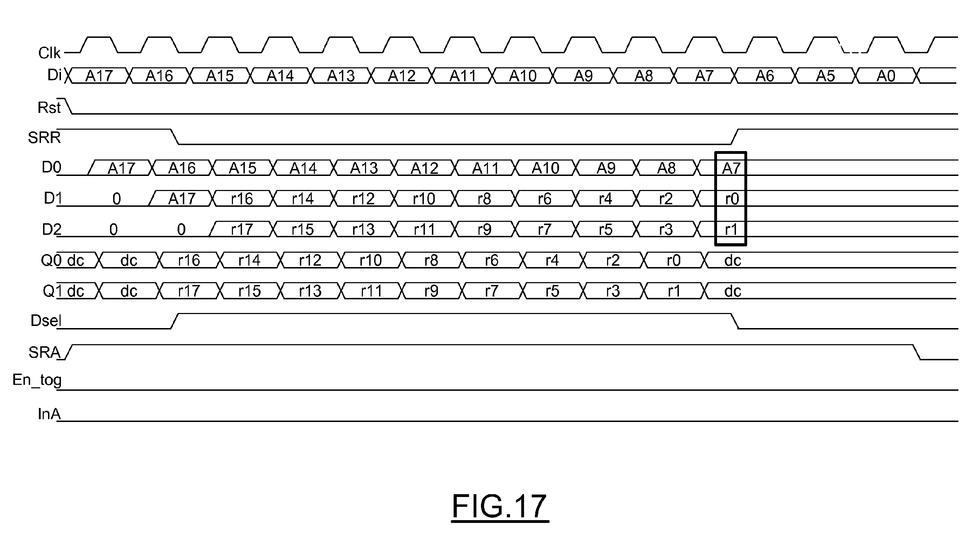

On se réfère maintenant plus particulièrement à la figure 17, qui est un chronogramme temporel illustrant une phase d'introduction de l'adresse, par exemple dans un mode de lecture aléatoire (« Random read », selon une dénomination anglosaxonne bien connue de l'homme du métier) dans lequel on va lire une donnée à une adresse quelconque, ou bien dans le cas de l'introduction d'une première adresse dans un mode de lecture séquentielle (sequential read) ou dans un mode de programmation par page.

Le chronogramme de la figure 17 est illustré avec les conventions habituellement utilisées en la matière. Ainsi, un trait disposé en dessous du nom du signal logique signifie que ce signal logique est à zéro.

On voit donc sur le chronogramme de la figure 17, qu'on a une introduction en série des bits d'adresses dans le registre d'adresse colonne RAC et dans le registre d'adresse ligne RAL, puis une mémorisation des bits. On a par ailleurs un calcul en temps réel de la congruence du numéro de ligne, modulo 3, puis une mémorisation de la congruence.

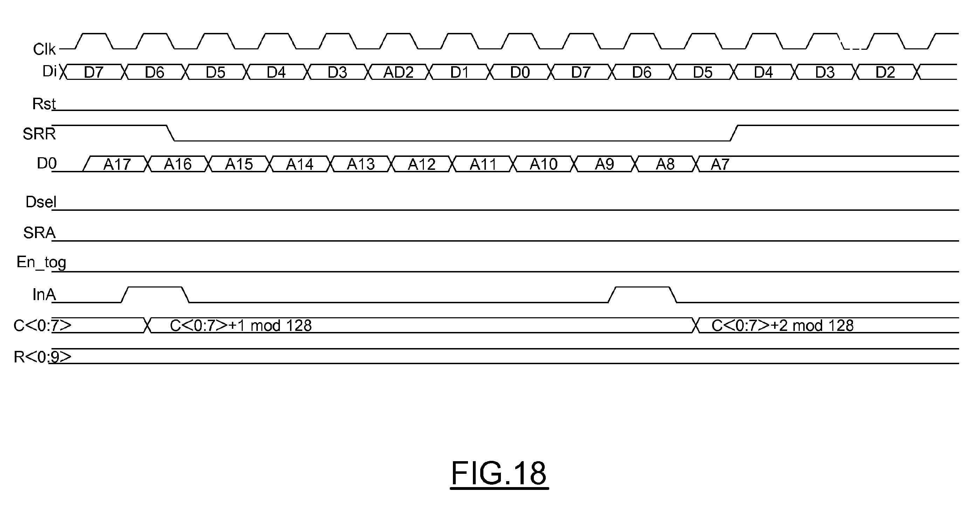

La figure 18 est un chronogramme temporel illustrant une phase d'introduction des données pour une écriture, par exemple dans une programmation en mode page.

Les données sont transmises par octets.

On a une incrémentation périodique de l'adresse colonne tous les huit coups d'horloge et l'adresse ligne n'est pas incrémentée. Par ailleurs, le registre de reste n'est pas incrémenté car comme on écrit dans la même page, la valeur du reste est figée (le type d'adressage page est figé). Et, seule la valeur du bit A7 va permettre de sélectionner, parmi les deux blocs de décodage BCDi désignés par la valeur du reste, celui qui devra être actif.

Bien entendu, dans une phase de programmation en mode page, dans laquelle on a une incrémentation périodique de l'adresse colonne tous les huit coups d'horloge, on calcule une seule fois la division euclidienne pour la première adresse, et ensuite on ne calcule plus cette division euclidienne puisqu'on incrémente l'adresse colonne.

Dans le cas d'une lecture séquentielle de la mémoire (sequential read) après avoir effectué la division euclidienne uniquement pour la première adresse rentrée, on va également incrémenter périodiquement les adresses. Cette fois-ci, puisque dans une commande de lecture séquentielle on peut lire tous les octets de la mémoire, le registre de reste va être incrémenté également séquentiellement.

Cette incrémentation va se faire dans la séquence 0 ; 1 ; 2 ; 0. Le registre de reste est incrémenté (InR=1) lorsqu'on est en mode de lecture séquentielle (En_tog=1) et en bout de page (tous les bits de colonne égaux à 1, ce qui correspond à Carry=1) et pas sur la dernière page (Carry2=0).

En effet, lorsqu'on se trouve sur la dernière page, le registre de reste ne doit pas être incrémenté.

De même, le registre de reste n'est pas incrémenté lors des phases de données en programmation en mode page (En_tog=0).

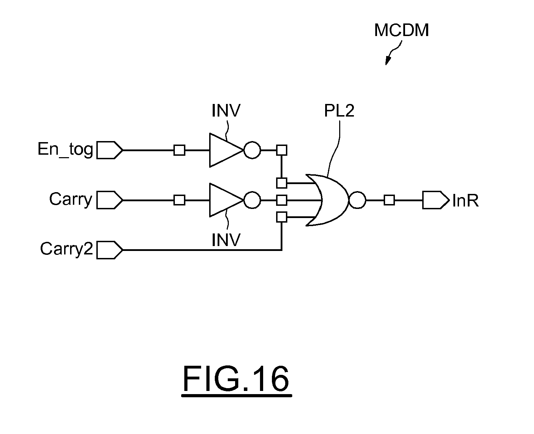

L'élaboration du signal de commande d'incrémentation InR du registre de reste est effectuée par les moyens de commande MCDM à l'aide d'un circuit logique illustré sur la figure 16.

Ce circuit logique comporte deux inverseurs INV recevant respectivement les signaux En_tog et Carry, ainsi qu'une porte logique PL2 (ici une porte NOR) dont deux entrées sont reliées respectivement aux deux sorties des deux inverseurs INV et dont la troisième entrée reçoit le signal Carry2. La sortie de la porte logique PL2 délivre le signal InR.

Par ailleurs, de façon que le registre de reste s'incrémente dans la séquence 0 ;1 ;2 ;0, c'est-à-dire en binaire 00 ; 01 ; 10 ; 00, sans perdre la valeur interdite 3 (m/2^{k}) ou 11 en binaire, il est prévu comme illustré sur la figure 14, des moyens de contrôle MCTRL comportant un circuit logique formé de portes logiques et d'inverseurs. Les moyens de contrôle MCTRL reçoivent en entrée les deux valeurs des deux étages D1 et D2 du registre de reste ainsi que le signal Inc et la sortie de la porte logique NON ET référencée PL3 agit sur l'entrée Rst des registres RG1 formant les trois étages ET0, ET1 et ET2 du registre de reste RRS.

Ainsi, une commande d'incrément (Inc=1) avec D2=1 et D1=0 initialise la bascule qui va réinitialiser de façon asynchrone le registre de reste dès que le signal d'horloge Clk passe à 1, ce qui permet d'obtenir la séquence 00 ; 01 ; 1,0 ; 00 (l'état 1,1 correspondant à un reste 3 étant comme indiqué précédemment un état interdit).

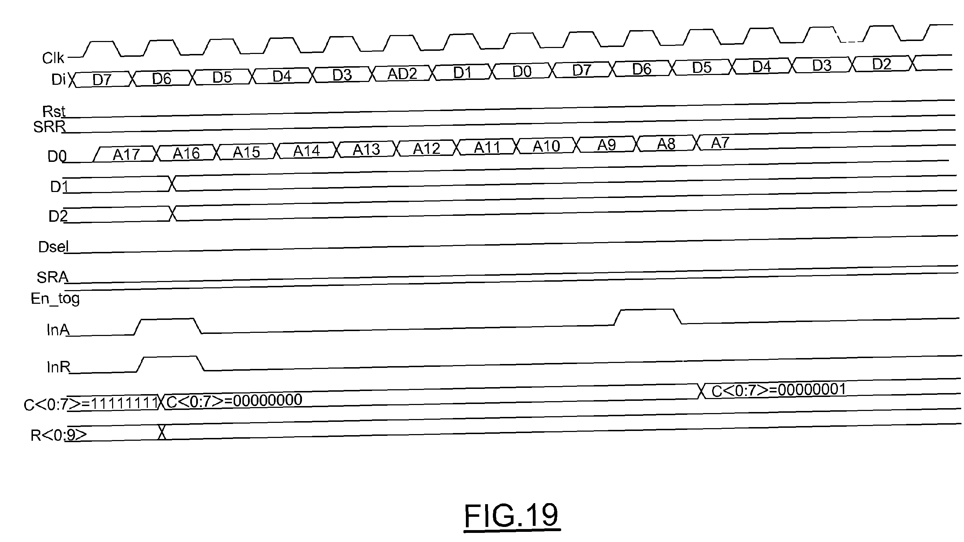

Si l'on revient maintenant sur la figure 19, le chronogramme qui y est représenté illustre un exemple de passage à une page suivante qui n'est pas la dernière page (le registre de reste est incrémenté).

Ainsi, les données sont lues par octets et on a une incrémentation périodique de l'adresse colonne tous les huit coups d'horloge, avec l'adresse ligne incrémentée conditionnellement en bout de colonne.

On a effectivement une incrémentation du registre de reste dans la séquence 0,1, 2,0 avec une absence d'incrémentation si l'on est en bout de page et sur la dernière page (Carry=1 et Carry2=1).

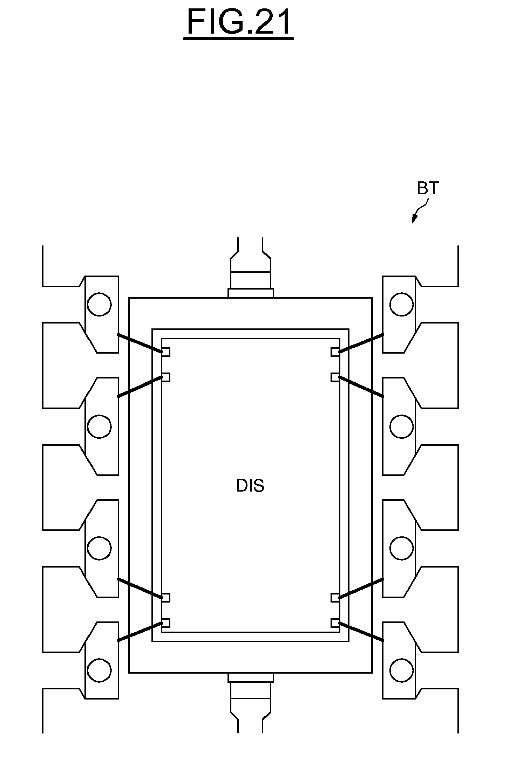

Le dispositif de mémoire DIS, qui peut être dans cet exemple une mémoire 2 Mégabits, peut ainsi rentrer dans la cavité d'un boîtier BT du type S08N (figure 21). Cette cavité a en effet par exemple une dimension de l'ordre de 2,5 mm x 4 mm ce qui représente actuellement la plus grande cavité réalisable industriellement de façon fiable.

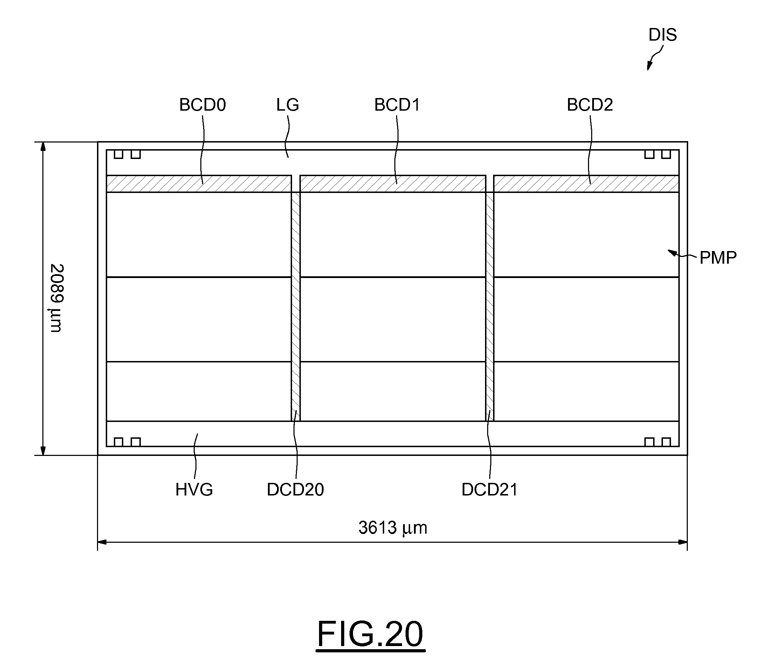

Le dispositif DIS qui vient d'être décrit avec un plan-mémoire physique de 683 lignes et 384 colonnes présente avec les circuits HVG de génération de la haute tension et le circuit logique LG, des dimensions compatibles avec un boîtier SO8N (figure 20).

Il convient de noter ici que, en pratique, si l'on revient maintenant à la figure 6, le deuxième décodeur de droite DCD21 est en pratique réalisé également jusqu'à atteindre la ligne physique LP682 et câblé de façon à pouvoir accéder également au bloc de 128 octets situé à droite du plan-mémoire physique sur la figure 6.

Bien que ceci ne soit pas indispensable, un tel câblage est généralement effectué d'une façon à ne pas rompre la symétrie du plan-mémoire physique. Ces emplacements-mémoire peuvent être par exemple utilisés pour stocker des paramètres de test inaccessibles à l'utilisateur.

Par ailleurs, de façon à limiter les effets de bord, on complétera en pratique le plan-mémoire physique PMP de la figure 20 en ajoutant de part et d'autre du plan-mémoire une ou deux lignes supplémentaires qui peuvent être des lignes fictives (« dummy rows »).

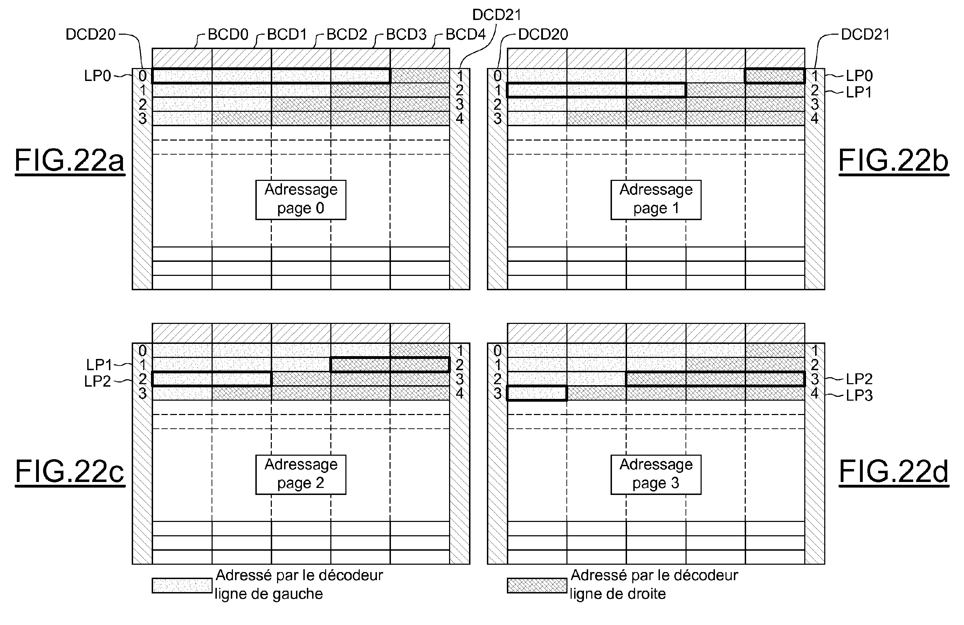

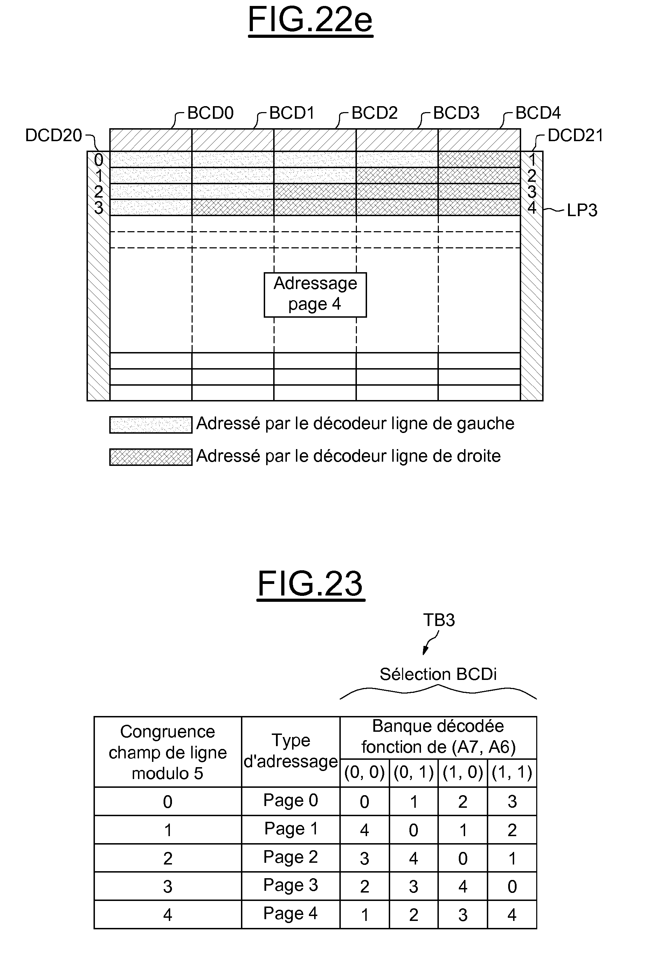

Les figures 22a à 22e illustrent un autre mode de réalisation d'un dispositif de mémoire selon l'invention.

Dans cet exemple, on suppose toujours que l'on est en présence d'une mémoire 2 Mégabits avec 256 colonnes logiques et 1024 lignes logiques. Cependant, cette fois-ci, chaque page logique comporte des blocs de 64 bits (2^{k}=64 ; k=6).

On a donc, comme illustré sur ces figures 22a à 22e, cinq quarts de page physique par page logique.

On obtient donc un plan-mémoire physique ayant 320 colonnes physiques et 820 lignes physiques. On effectue cette fois-ci une division euclidienne par 5 (m/2^{k}) et il y a donc cinq types d'adressage page différents possibles.

Le dispositif de mémoire comporte là encore deux deuxièmes décodeurs DCD20 et DCD21 qui sont cette fois-ci placés aux deux extrémités du plan-mémoire physique.

Cette fois-ci, les moyens de décodage comportent cinq blocs de décodage BCDO-BCD4.

La sélection d'un bloc de décodage parmi cinq s'effectue là encore avec la valeur du reste et avec les deux bits de poids fort A7 et A6 du champ d'adresse ligne.

Chaque deuxième décodeur omet cette fois-ci le décodage d'une ligne logique sur cinq au lieu d'une ligne logique sur trois comme décrit précédemment.

Le registre de reste comporte quatre étages au lieu de trois et la valeur du reste peut aller de 0 à 4 au lieu de 0 à 2.

La table de vérité du calcul du reste est plus grande de même que la table de vérité de la sélection des blocs de décodage BCDi qui correspond à la table TB3 de la figure 23.

Plus précisément, dans un adressage type page 0, les 256 octets de cette page sont stockés sur les quatre premiers blocs de 64 octets de la page physique LP0, et sont accédés par le décodeur DCD20 en combinaison avec l'un des blocs de décodage BCDO-BCD3.

Dans un adressage type page 1, les 64 premiers octets de cette page logique sont stockés sur les 64 dernières colonnes de la page physique LP0 et sont accédés par le décodeur DCD21 tandis que les trois autres blocs de 64 octets de cette page logique 1 sont situés sur les trois premiers blocs de 64 colonnes de la page physique LP1 et sont accédés par le décodeur DCD20.

En ce qui concerne un adressage de type page 2, les octets d'une telle page se partagent entre les deux pages physiques LP1 et LP2 comme illustré sur la figure 22c et sont accédés par les décodeurs DCD21 et DCD20.

Dans un adressage de type page 3 (figure 22d) la page logique se répartit pour trois quarts sur la page physique LP2 et pour le dernier quart sur la page physique LP3. Les trois premiers quarts sont accédés par le décodeur de droite DCD21 tandis que le dernier quart est accédé par le décodeur de gauche DCD20.

Enfin, pour un adressage de type page 4, tous les octets de cette page sont stockés sur les quatre derniers blocs de la page physique LP3 et sont accédés uniquement par le décodeur droite DCD21.

L'homme du métier saura modifier les moyens de calcul du reste ainsi que le module de sélection de façon à s'adapter à cette nouvelle configuration.

Bien entendu, la capacité du circuit peut être différente de 2 Mégabits, et la taille de la page logique différente de 256 bits. On peut ainsi considérer une mémoire de 4 Mégabits et des pages de 512 bits.

D'une façon plus générale, dans le cas d'une mémoire organisée par pages, dont une page comporte 2^{p} colonnes (ou emplacements-mémoire ; octets par exemple), une page physique comporte 2^{p}+2^{k} octets, avec k variant de 0 à p-1.

Ceci est vrai sauf pour la dernière page physique qui est plus réduite (elle comporte 2^{p} octets) bien qu'elle puisse être complétée artificiellement pour les raisons évoquées plus haut.

La première page physique comporte la page logique 0 et les 2^{k} premiers octets de la page logique 1.

La seconde page physique comporte les 2^{p}-2^{k} octets restants de la page logique 1 et les 2^{k+1} premiers octets de la page physique 2.

La troisième page physique comporte les 2^{p}-2^{k+1} octets restants de la page logique 2 et les 3x2^{k} premiers octets de la page physique 3.

La n^{ème} page physique se termine par les n.2^{k} premiers octets de la page physique n. Si n est égal à 2^{p-k}, alors la page physique suivante sera organisée comme la première.

Ainsi, si p=8 et k=7, la troisième page est organisée comme la première, tandis que si k est égal à p-2 et 2^{p-k} est égal à 4, la cinquième page est organisée comme la première.

L'adressage du plan-mémoire en colonne se fait par bloc de 2^{k} octets.

Le décodage d'adresse utilise une division euclidienne par 1+2^{p}/2^{k}_{.}

Le reste de la division euclidienne de l'adresse logique par « 1+2^{p}/2^{k} » est utilisé pour déterminer le bloc de 2^{k} octets adressé.

L'architecture décrite ci-avant dans les modes de réalisation précédents est analogue, mais bien entendu, en fonction des valeurs de p et de k, le nombre d'étages des registres d'adresses lignes/colonnes et du registre de reste change.

Le nombre de blocs de décodage BCDi change.

Les tables de vérité du calcul de reste et du module de sélection MSEL diffèrent.

Enfin, l'invention n'est pas limitée à une mémoire de type EEPROM à protocole série mais peut s'appliquer à d'autres types de mémoires comme par exemple des mémoires RAM ou SRAM avec des modes page et des lectures en mode « burst » de même qu'à des mémoires ROM avec des modes « burst ».

## Revendications

1. Dispositif de mémoire, **caractérisé en ce qu'**il comprend un plan mémoire physique (PMP) comportant m premières rangées physiques (RGP1i) s'étendant selon une première direction et n deuxièmes rangées physiques (RGP2j) s'étendant selon une deuxième direction, des moyens de réception (RAC, RAL) pour recevoir une adresse logique (ADR) désignant une première rangée logique (RG1i) et une deuxième rangée logique (RG2j) d'un plan mémoire logique matriciel (PML), possédant 2^{p} premières rangées logiques s'étendant selon la première direction et 2^{q} deuxièmes rangées logiques s'étendant selon la deuxième direction, **en ce que en ce que** m et n sont chacun différents d'une puissance de deux, m étant un multiple de 2^{k}, k étant inférieur ou égal à p, et le produit de m par n étant égal à l'entier le plus proche par excès de 2^{p+q}, et **en ce qu'**il comprend des moyens d'adressage du plan mémoire physique (PMP) configurés pour adresser une première rangée physique et une partie seulement d'une deuxième rangée physique à partir du contenu de ladite adresse logique reçue et du reste d'une division euclidienne d'une partie (A17-A8) du contenu de cette adresse logique reçue par m/2^{k} .

2. Dispositif selon la revendication 1, dans lequel ladite adresse logique reçue (ADR) comporte un premier champ (CH1) associé à ladite première rangée logique et un deuxième champ (CH2) associé à ladite deuxième rangée logique, et les moyens d'adressage comportent des premiers moyens de décodage comportant des moyens de calcul (RRS, MCLR) configurés pour effectuer la division euclidienne du contenu dudit deuxième champ (CH2) par m/2^{k} et des premiers moyens de sélection (MSEL, BCDi) configurés pour sélectionner ladite première rangée physique à partir du contenu dudit premier champ (CH1) et dudit reste de la division euclidienne, et des deuxièmes moyens de décodage (DCD20, DCD21) configurés pour adresser ladite partie de ladite deuxième rangée physique à partir du contenu dudit deuxième champ (CH2).

3. Dispositif selon la revendication 2, étant à protocole série et dans lequel les moyens de calcul (RRS, MCLR) sont configurés pour effectuer ladite division euclidienne à la volée.

4. Dispositif selon la revendications 3, dans lequel les moyens de calcul comportent un registre de reste (RRS) destiné à recevoir séquentiellement les bits du deuxième champ (CH2), bit de poids fort (A17) en tête, et un circuit logique (MCLR) rebouclé sur le registre de reste et configuré pour délivrer séquentiellement au registre de reste la valeur binaire du reste de la division euclidienne par m/2^{k} du dividende formé par le contenu du registre de reste concaténé à droite par le bit courant reçu du deuxième champ.

5. Dispositif selon l'une des revendications 2 à 4, dans lequel les moyens de réception comportent un premier registre d'adresse (RAC) configuré pour stocker le contenu du premier champ (CH1) et un deuxième registre d'adresse (RAL) configuré pour stocker le contenu du deuxième champ (CH2), le premier registre d'adresse (RAC) possédant une sortie de retenue (Carry) connectée à une entrée d'incrémentation (Inc) du deuxième registre d'adresse (RAL).

6. Dispositif selon l'une des revendications 2 à 5, dans lequel les deuxièmes moyens de décodage comportent plusieurs deuxièmes décodeurs (DCD20, DCD21) capables de décoder l'ensemble des deuxièmes rangées logiques, chaque deuxième décodeur étant configuré pour décoder certaines seulement des deuxièmes rangées logiques, et le décodeur ou chaque décodeur affecté à la deuxième rangée logique désignée par le contenu du deuxième champ (CH2) de ladite adresse logique reçue est configuré pour accéder à une partie seulement d'une deuxième rangée physique.

7. Dispositif selon la revendication 6, comprenant seulement deux deuxièmes décodeurs (DCD20, DCD21).

8. Dispositif selon la revendication 7, dans lequel l'un des deuxièmes décodeurs (DCD20) est configuré pour pouvoir décoder séquentiellement lesdites deuxièmes rangées logiques à partir de la première en omettant de décoder une rangée logique sur m/2^{k}, et l'autre deuxième décodeur (DCD21) est configuré pour pouvoir décoder séquentiellement lesdites deuxièmes rangées logiques à partir de la deuxième en omettant de décoder une rangée logique sur m/2^{k}.

9. Dispositif selon l'une des revendications précédentes, dans lequel m est égal à 2^{p} + 2^{k}, k étant un entier positif ou nul et inférieur ou égal à p-1.

10. Dispositif selon la revendication 9, dans lequel les 2^{q} deuxièmes rangées logiques du plan mémoire logique correspondent à 2^{q} pages logiques comportant chacune 2^{p} emplacements-mémoire logiques configurés pour stocker respectivement 2^{p} données, et le plan mémoire physique (PMP) comporte n pages physiques (LPi) dont n-1 (LPO-LP681) sur les n comportent chacune 2^{p} + 2^{k} emplacements-mémoire physiques et correspondent chacune à une page logique et à une partie d'une page logique de rang voisin, et dont l'une (LP682) comporte 2^{p} emplacements-mémoire physiques et correspond à une partie au moins d'une page logique.

11. Dispositif de mémoire, comprenant un plan-mémoire comportant n lignes et m colonnes, des moyens de décodage ligne et des moyens de décodage colonne, **caractérisé en ce que** n et m sont chacun différents d'une puissance de deux, **en ce que** m est un multiple de 2^{k}, k étant un entier positif, **en ce que** les moyens de décodage colonne comprennent plusieurs blocs de décodage (BCDi) respectivement affectés à des blocs de 2^{k} colonnes, et **en ce que** les moyens de décodage ligne comprennent plusieurs décodeurs lignes (DCD20, DCD21) configurés chacun pour accéder à une partie seulement du plan-mémoire (PMP).

12. Dispositif selon la revendication 11, dans lequel les moyens de décodage ligne comportent deux décodeurs lignes seulement (DCD20, DCD21).

13. Dispositif selon l'une des revendications précédentes, dans lequel le plan mémoire est du type non volatile et électriquement effaçable et programmable, en particulier organisé en pages-mémoire.

14. Boîtier contenant un dispositif de mémoire selon l'une des revendications 1 à 13.

15. Boîtier selon la revendication 14, du type SO8N ou TSSOP8, contenant un dispositif de mémoire de capacité supérieure à 1 Mégabits.

16. Procédé d'adressage d'un dispositif de mémoire, comprenant un plan mémoire physique (PMP) correspondant à un plan-mémoire logique matriciel, possédant 2^{p} premières rangées logiques s'étendant selon une première direction et 2^{q} deuxièmes rangées logiques s'étendant selon une deuxième direction, le plan mémoire physique comportant m premières rangées physiques s'étendant selon la première direction et n deuxièmes rangées physiques s'étendant selon la deuxième direction, m et n étant chacun différent d'une puissance de deux, m étant un multiple de 2^{k}, k étant inférieur ou égal à p, et le produit de m par n étant égal à l'entier le plus proche par excès de 2^{p+q}, procédé comprenant un premier mode d'adressage comportant une réception d'une adresse logique (ADR) désignant une première rangée logique et une deuxième rangée logique et un adressage d'une première rangée physique et d'une partie seulement d'une deuxième rangée physique à partir du contenu de ladite adresse logique (ADR) et du reste d'une division euclidienne (100) d'une partie du contenu de cette adresse logique par m/2^{k} .

17. Procédé selon la revendication 16, dans lequel ladite adresse logique comporte un premier champ associé à ladite première rangée logique et un deuxième champ associé à ladite deuxième rangée logique, et ledit adressage comporte un calcul (100) du reste de la division euclidienne, du contenu dudit deuxième champ par m/2^{k} et une sélection de ladite première rangée physique à partir du contenu dudit premier champ et dudit reste de la division euclidienne, et un adressage de ladite partie de ladite deuxième rangée physique à partir du contenu dudit deuxième champ.

18. Procédé selon la revendication 17, appliqué à un dispositif de mémoire à protocole série, dans lequel le calcul (100) du reste de la division euclidienne est effectué à la volée.

19. Procédé selon l'une des revendications 17 à 18, dans lequel l'adressage des parties de deuxièmes rangées physiques s'effectue avec plusieurs deuxièmes décodeurs (DCD20, DCD21) capables de décoder l'ensemble des deuxièmes rangées logiques, dans lequel on configure chaque deuxième décodeur pour décoder certaines seulement des deuxièmes rangées logiques, et on accède à une partie seulement d'une deuxième rangée physique avec le décodeur ou chaque décodeur affecté à la deuxième rangée logique désignée par le contenu du deuxième champ de ladite adresse logique reçue.

20. Procédé selon l'une des revendications 16 à 19, pour l'adressage d'un plan mémoire dans lequel m est égal à 2^{p} + 2^{k}, k étant un entier positif ou nul et inférieur ou égal à p-1.

21. Procédé selon la revendication 20, pour l'adressage d'un plan mémoire dans lequel les 2^{q} deuxièmes rangées logiques du plan mémoire logique correspondent à 2^{q} pages logiques comportant chacune 2^{p} emplacements-mémoire logiques configurés pour stocker respectivement 2^{p} données, et le plan mémoire physique (PMP) comporte n pages physiques dont n-1 sur les n comportent chacune 2^{p} + 2^{k} emplacements-mémoire physiques et correspondent chacune à une page logique et à une partie d'une page logique de rang voisin, et dont l'une comporte 2^{p} emplacements-mémoire physiques et correspond à une partie au moins d'une page logique.
